# FASCICULE DE BREVET EUROPEEN

(11) **EP 3 586 376 B1**
(45) Date de publication et mention de la délivrance du brevet: **05.05.2021**
(21) Numéro de dépôt: 18704579.4
(22) Date de dépôt: 19.02.2018
(51) Int. Cl.: H01L 31/0304, H01L 31/0735

(54) **CELLULE PHOTOVOLTAÏQUE MULTI-JONCTIONS DE TYPE III-V SUR SUBSTRAT SILICIUM ET SON PROCÉDÉ DE FABRICATION**
FOTOVOLTAISCHE ZELLE MIT MEHREREN III-V-VERBINDUNGEN AUF EINEM SILICIUMSUBSTRAT UND VERFAHREN ZUR HERSTELLUNG DAVON
PHOTOVOLTAIC CELL WITH MULTIPLE III-V JUNCTIONS ON A SILICON SUBSTRATE AND METHOD FOR THE PRODUCTION THEREOF

(30) Priorité: 23.02.2017 FR 1700179
(43) Date de publication de la demande: 01.01.2020
(73) Titulaire: Commissariat à l'Énergie Atomique et aux Énergies Alternatives, 75015 Paris (FR); Thales, 92400 Courbevoie (FR)
(72) Inventeur: DECOBERT, Jean, 91620 Nozay (FR); LELARGE, François, 75012 Paris (FR); TOURNIE, Eric, 34095 Montpellier Cedex 5 (FR)
(74) Mandataire: Marks & Clerk France
(86) Numéro de dépôt international: PCT/EP2018/054047
(87) Numéro de publication internationale: WO 2018/153819

(56) Documents cités:
- DE-A1-102010 001 420
- DIMROTH FRANK ET AL: "Comparison of Direct Growth and Wafer Bonding for the Fabrication of GaInP/GaAs Dual-Junction Solar Cells on Silicon", IEEE JOURNAL OF PHOTOVOLTAICS, I E E E, US, vol. 4, no. 2, 1 mars 2014 (2014-03-01), pages 620-625, XP011540308, ISSN: 2156-3381, DOI: 10.1109/JPHOTOV.2014.2299406 [extrait le 2014-02-19]
- NIKHIL JAIN ET AL: "III-V Multijunction Solar Cell Integration with Silicon: Present Status, Challenges and Future Outlook", ENERGY HARVESTING AND SYSTEMS, vol. 1, no. 3-4, 1 janvier 2014 (2014-01-01), XP055251645, ISSN: 2329-8774, DOI: 10.1515/ehs-2014-0012
- VEINBERG-VIDAL ELIAS ET AL: "Manufacturing and Characterization of III-V on Silicon Multijunction Solar Cells", ENERGY PROCEDIA, ELSEVIER, NL, vol. 92, 23 septembre 2016 (2016-09-23), pages 242-247, XP029715907, ISSN: 1876-6102, DOI: 10.1016/J.EGYPRO.2016.07.066
- HAMON G ET AL: "Direct growth of crystalline silicon on GaAs by low temperature PECVD: Towards hybrid tunnel junctions for III-V/Si tandem cells", 2016 IEEE 43RD PHOTOVOLTAIC SPECIALISTS CONFERENCE (PVSC), IEEE, 5 juin 2016 (2016-06-05), pages 1895-1897, XP033007962, DOI: 10.1109/PVSC.2016.7749951

## Description

L'invention porte sur une cellule photovoltaïque multi-jonctions de type III-V et sur son procédé de fabrication.

Les cellules photovoltaïques en silicium cristallin ont atteint leurs limites, en termes d'efficacité de conversion énergétique (rendement), il y a plus de 12 ans, avec un record d'efficacité de 25% en conditions de laboratoire. Les marges d'amélioration sont extrêmement réduites et la recherche se concentre désormais sur la réduction des coûts.

Certains matériaux III-V sont beaucoup mieux adaptés que le silicium pour les applications photovoltaïques, car ils présentent une bande interdite directe, une plus grande mobilité des porteurs et une bande interdite mieux adaptée au spectre solaire. Par exemple, les cellules mono-jonction en GaAs présentent un rendement théorique de l'ordre de 33% (sans concentration du rayonnement solaire), et des rendements jusqu'à 28,8% ont effectivement été obtenus en laboratoire.

Le concept le plus prometteur pour améliorer encore le rendement est celui des cellules photovoltaïques multi-jonctions, comprenant plusieurs jonctions PN présentant des largeurs de bande interdite différentes, empilées et connectées en série. Cela permet une meilleure utilisation du spectre solaire, réduisant les pertes par thermalisation. Ces structures sont généralement réalisées sous forme monolithique ; se pose donc le problème d'assurer une bonne qualité cristalline.

A cette fin, il est connu d'utiliser des matériaux semi-conducteurs présentant des paramètres de maille accordés ; tel est le cas de l'architecture GaInP/GaAs/Ge sur substrat en germanium, qui est la plus couramment utilisée et qui a permis d'atteindre un rendement de 41,6% sous éclairage solaire concentré d'un facteur 364 (Spectrolab). Cependant, la largeur de bande interdite de la jonction en germanium (0,67 eV) n'est pas optimale ; une largeur de bande de l'ordre de 1 eV serait préférable car elle permettrait d'obtenir un rendement encore meilleur. Un rendement encore plus élevé (44% sous éclairage concentré d'un facteur 949) a été obtenu par la société Solar Junctions en utilisant une structure InGaP/GaAs/InGaAs sur substrat en GaAs.

La condition d'accord de paramètre de maille est très contraignante, et d'autres techniques ont été développées pour s'en affranchir en tout ou en partie.

Une approche prometteuse, mais encore mal maitrisée, consiste à réaliser une adhésion (« wafer bonding ») entre deux empilements photovoltaïques présentant des paramètres de maille incompatibles et fabriqués par croissance sur des substrats différents, par exemple InP et GaAs.

Il a même été possible - mais avec un rendement peu satisfaisant (23% avec un éclairage concentré d'un facteur 24) - de reporter un empilement monolithique de cellules photovoltaïques III-V sur une cellule photovoltaïque mono-jonction en silicium.

Encore une autre approche est celle dite « métamorphique », consistant à fabriquer des structures semi-conductrices ne respectant pas la condition d'accord de paramètre de maille, mais présentant des couches tampon empêchant la propagation des dislocations dans les régions actives. A ce jour les meilleurs résultats (37,7% sans concentration) ont été obtenus par Sharp grâce à une structure métamorphique inversée fabriquée sur substrat Ge. « Inversée » signifie ici que la jonction de plus grande bande interdite se trouve près du substrat de croissance, ce qui n'est pas souhaitable ; il est donc nécessaire de reporter la structure sur un autre substrat, en inversant son orientation, et la détacher du substrat de croissance qui peut être réutilisé. Dans ce cas particulier, une approche à accord de paramètre de maille (pour les deux premières jonctions en AlInGaP et InGaAs sur substrat Ge) a été combinée avec une approche métamorphique (pour la dernière jonction en InGaAs, séparée des deux autres par une structure tampon).

Quelle que soit l'approche retenue, dans la plupart des cas on a recours à des substrats de croissance en matériaux III-V ou en germanium, qui sont coûteux et nécessitent des procédés complexes. Pour remédier à ces inconvénients, il a été proposé de réaliser des cellules photovoltaïques III-V sur substrat silicium - très peu coûteux et permettant de bénéficier du savoir faire développé dans l'industrie microélectronique. Cependant, cela est difficile pour deux raisons :
- le paramètre de maille du silicium est très différent de celui de la plupart de ces matériaux (désadaptation d'environ 4% avec GaAs), ce qui rend difficile l'obtention de structures présentant une bonne qualité cristalline et une faible densité de dislocations ;
- le coefficient de dilatation thermique est aussi très différent ; cela induit l'apparition de contraintes en tension dans les structures III-V épitaxiées lors de la phase de refroidissement qui suit la croissance, qui peuvent conduire à leur fissuration.

Un accord de paramètre de maille avec un substrat en silicium peut être obtenu en utilisant des composés quaternaires GaN_{y}(PₓAs₁₋ₓ)_{1-y}. Cependant ces matériaux présentent une faible longueur de diffusion des porteurs minoritaires, ce qui limite leurs performances.

L'approche métamorphique sur substrat silicium a également été développée, par exemple en utilisant des couches tampons très épaisses (10 µm environ) en alliage SiGe a composition graduée. Voir à ce propos C. L. Andre, J. A. Carlin, J. J. Boeckl, D. M. Wilt, M. A. Smith, A. J. Pitera, M. L. Lee, E. A. Fitzgerald, and S. A. Ringel, « Investigation of high-performance GaAs solar cells grown on Ge-Si/sub 1-x/Ge/Sub x/ -Si substrates », IEEE Transactions on Electron Devices 52, 1055 (2005). Cependant, le paramètre de maille des alliages SiGe n'est pas compatible avec des matériaux III-V présentant une bonne absorption dans le proche infrarouge. En outre, la croissance épitaxiale d'une telle structure prend beaucoup de temps, ce qui rend coûteux le procédé de fabrication de la cellule photovoltaïque

Dimroth et al., "Comparison of Direct Growth and Wafer Bonding for the Fabrication of GaInR/GaAs Dual-JunctionSolar Cells on Silicon", IEEE Journal of Photovoltaics, Vol. 4, No. 2, pages 620-625 (2014) décrit une cellule photovoltaïque multi-jonctions avec une couche tampon de type III-V.

L'invention vise à surmonter les inconvénients précités de l'art antérieur. Plus précisément elle vise à permettre la fabrication de cellules photovoltaïques multi-jonctions de type III-V sur substrat silicium par un procédé simple et économique, sans pour autant sacrifier leurs performances.

Conformément à l'invention, ce but est atteint grâce à l'utilisation d'une couche tampon en alliage à base d'antimoine et aluminium, avec la présence d'au moins un autre élément du groupe V, notamment As (arsenic). Ces alliages, que l'on peut désigner de manière générale par Al-V-Sb présentent un paramètre de maille très différent de celui du substrat en silicium, mais relaxent les contraintes en l'espace de quelques couches atomiques seulement. Ainsi, même une couche tampon de quelques nanomètres d'épaisseur permet d'obtenir une faible densité de défauts (de l'ordre de 10⁶/cm²), et notamment de dislocations vis. Cela a été démontré dans la cas particulier d'un alliage binaire AlSb, voir à ce propos G. Balakrishnan, S. Huang, L. R. Dawson, Y.-C. Xin, P. Conlin, D. L. Huffaker, « Growth mechanisms of highly mismatched AlSb on a Si substrate », Applied Physics Letters 86, 034105 (2005). L'alliage binaire AlSb présente toutefois un paramètre de maille qui n'est pas compatible avec les meilleurs matériaux III-V disponibles pour la réalisation de cellules photovoltaïques. Par contre, la composition d'un alliage Al-V-Sb peut être choisie de telle sorte que son paramètre de maille soit accordé avec celui de certains alliages des familles AlGaInAs et GaInAsP, qui sont connus pour permettre la réalisation de cellules photovoltaïques multi-jonctions à haut rendement, voir par exemple I. Mathews, D. O'Mahony, A. Gocalinska, E. Pelucchi, K. Thomas, A.P. Morrison, B. Corbett, « InAlAs and InGaAs solar cells for use in monolithic triple-junction solar cells with improved spectrum splitting », 28th European Photovoltaic Solar Energy Conference and Exhibition (2013).

Une couche tampon en AlSb (en soi inadaptée aux applications photovoltaïques) a déjà été utilisée pour fabriquer des lasers en GaSb sur substrat Si, voir A. Castellano, L. Cerutti, G. Narcy, J.B. Rodriguez, A.Garreau, F. Lelarge « GaSb lasers grown on Silicon substrate emitting in the telecom wavelength range » 2016 Compound Semiconductor Week (CSW2016), 26 - 30 juin 2016. Cela montre que des couches tampon à base de Al et Sb permettent également d'absorber les contraintes induites par les différences de paramètre de maille et de coefficient de dilatation thermique entre le substrat et les couches actives épitaxiées.

Un objet de l'invention est donc une cellule photovoltaïque multi-jonctions comprenant un substrat en silicium monocristallin ; une couche tampon en alliage au moins ternaire de type III-V comprenant de l'aluminium, de l'antimoine et au moins un autre élément du group V, déposée par épitaxie au-dessus dudit substrat ; et une hétérostructure active déposée par épitaxie au-dessus de ladite couche tampon, formée d'au moins deux alliages différents choisis parmi les familles AlGaInAs et GaInAsP présentant des paramètres de maille adaptés entre eux et avec celui de la couche tampon et comprenant au moins deux jonctions PN empilées présentant des largeurs de bande interdite différentes.

Un autre objet de l'invention est un procédé de fabrication d'une cellule photovoltaïque multi-jonctions comprenant les étapes suivantes :
a) fabrication, par dépôt épitaxial sur une surface d'un substrat en silicium monocristallin, d'une couche tampon en alliage de type III-V comprenant au moins de l'aluminium, de l'antimoine et au moins un autre élément du group V; et
b) fabrication, par dépôt épitaxial sur ladite couche tampon, d'une hétérostructure active formée d'au moins deux alliages différents choisis parmi les familles AlGaInAs et GaInAsP présentant des paramètres de maille adaptés entre eux et avec celui de la couche tampon et comprenant au moins deux jonctions PN empilées présentant des largeurs de bande interdite différentes.

Les revendications dépendantes portent sur des modes de réalisation particuliers.

D'autres caractéristiques, détails et avantages de l'invention ressortiront à la lecture de la description faite en référence aux dessins annexés donnés à titre d'exemple et qui représentent, respectivement :
- la figure 1, un diagramme reliant le paramètre de maille à la largeur de bande interdite pour des matériaux semi-conducteurs pouvant être utilisés pour la mise en œuvre de l'invention ; et
- les figures 2A à 2C, des structures intermédiaires obtenues lors de la mise en œuvre d'un procédé selon un mode de réalisation de l'invention ; et
- la figure 2D, une cellule photovoltaïque selon un mode de réalisation de l'invention.

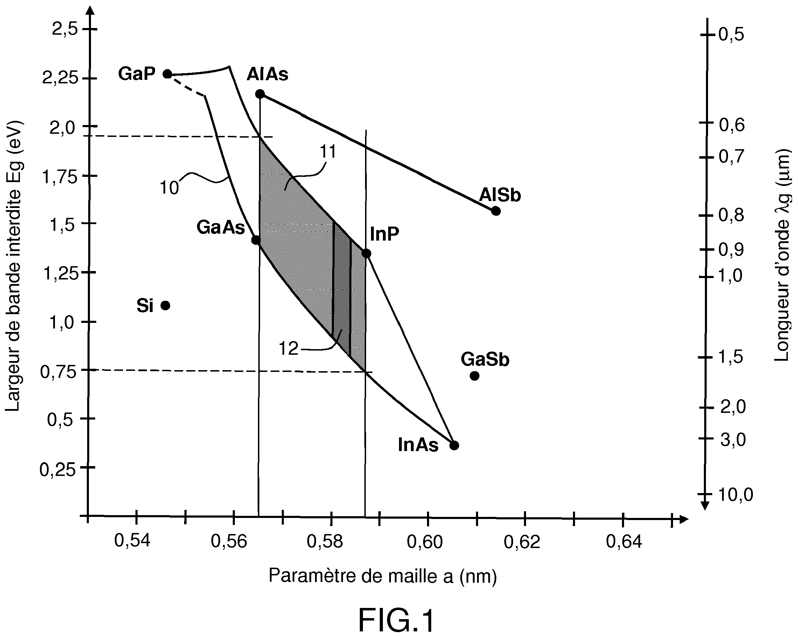

Sur la figure 1, la région 10 représente toutes les valeurs de paramètre de maille « a » et de largeur de bande interdite « Eg » qui peuvent être obtenues en réalisant des alliages quaternaires avec structure cristalline de type zinc-blende à partir des éléments Al, Ga, In (groupe III) et P, As (groupe V) dans diverses proportions. On peut désigner ces alliages par la formule générique (Al_{z}Ga-_{1-z})_{w}In_{1-w}As_{1-y}P_{y} où 0≤z≤1, 0≤w≤1, 0≤y≤1 et exactement un coefficient parmi « z » et « y » est nul.

Le paramètre de maille (à 300 K) de ces alliages peut varier entre 5,4508 Å (Angstrôm) pour le cas limite du GaP et 6,0583 Å pour celui de l'InAs. La largeur de bande interdite (également à 300 K), quant à elle, peut varier entre 0,417 eV (InAs) et plus de 2,25 eV (alliage InGaP). Ce qui est intéressant est que, pour une même valeur du paramètre de maille « a », il est possible de trouver des compositions d'alliages présentant différentes valeurs de Eg. Plus particulièrement, dans la région 5,6533 Å < a < 5,869 Å (référence 11 sur la figure) ces alliages permettent de couvrir une plage d'énergie Eg de largeur significative, de l'ordre de 0,5 eV, et correspondant à des photons dans les plages visible (350 - 750 nm, soit 1,65 - 2,75 eV) et proche infrarouge (750 - 1400 nm, soit 0,89 - 1,65 eV) du spectre électromagnétique. Les longueurs d'onde λ_{g} correspondant aux largeurs de bande interdite Eg sont indiquées sur l'échelle de droite de la figure. Il est donc possible de réaliser plusieurs jonctions PN présentant des largeurs de bande interdite (et donc des longueurs d'onde d'absorption lumineuse) différentes tout en ayant des paramètres de maille strictement identiques.

En fait, pour la réalisation de cellules photovoltaïques, il est préférable de se limiter à la région 5,80 Å ≤ a ≤ 5,83 Å, centrée autour d'une valeur optimale a=5,815 Å qui, compte tenu des caractéristiques du spectre solaire, maximise le rendement énergétique. Cette région préférée est désignée par la référence 12 sur la figure. Il est intéressant de noter que les matériaux des régions 10, 11 et 12 permettent de réaliser, en plus des jonctions PN utilisées pour absorber la lumière, toutes les couches intermédiaires nécessaires à la fabrication d'une cellule photovoltaïque multi-jonctions (par exemple les jonctions tunnel séparant lesdites jonctions PN), qui doivent également être accordées en maille.

Les paramètres de maille considérés ici sont très différents de celui du silicium servant de substrat (5,431 Å). C'est pourquoi l'invention propose d'utiliser, entre le substrat en silicium et l'hétérostructure « active » en alliages (Al_{z}Ga_{1-z})_{w}In_{1-w}As_{1-y}P_{y}, une couche tampon en alliage III-V comprenant de l'antimoine, de l'aluminium et au moins un troisième élément du groupe V. La composition de cette couche tampon est choisie pour obtenir un accord de paramètre de maille pratiquement parfait (avec une tolérance qui est généralement inférieure ou égale à 0,1% et typiquement de l'ordre de 0,01%, ou 100 ppm) avec l'hétérostructure active. En particulier on peut utiliser un alliage AlAsₓSb₁₋ₓ avec 0,56≤x<1 assurant l'accord de paramètre de réseau avec les alliages (Al_{z}Ga_{1-z})_{w}In_{1-w}As_{1-y}P_{y} de la région 11, ou de préférence avec 0,64≤x≤0,71 assurant l'accord de paramètre de réseau avec les alliages (Al_{z}Ga_{1-z})_{w}In_{1-w}As_{1-y}P_{y} de la région 12.

La couche tampon présente un désaccord de paramètre de maille très significatif, de l'ordre de 7%, avec le substrat en silicium d'orientation (100), ce qui induit des contraintes importantes. Ces contraintes, cependant, relaxent complètement dans les premières couches atomiques, sans propagation des défauts dans la direction verticale. A l'interface avec le substrat, l'énergie élastique est principalement dissipée par la formation d'ilots suivie par leur coalescence et l'apparition d'ondulations dans le matériau massif. Les dislocations qui permettent d'accommoder les désaccord paramétrique sont essentiellement parallèles au plan (100), et il y a très peu de dislocations selon les plans denses {111}. Ainsi, les défauts de la couche tampon ne se propagent pas dans l'hétérostructure active.

L'épaisseur de la couche tampon est généralement comprise entre 2 - 3 nm et 100 nm, bien que des épaisseurs plus importantes (par exemple jusqu'à 1 µm) puissent également être utilisées.

Le plus souvent, une cellule photovoltaïque selon l'invention comprend trois jonctions PN empilées, séparées par deux jonctions tunnel. La jonction inférieure, plus proche du substrat, présente la largeur de bande interdite la plus faible - typiquement, la plus faible pouvant être obtenue pour le paramètre de maille imposé par la couche tampon. La jonction supérieure, plus éloignée du substrat, présente la largeur de bande interdite la plus élevée - typiquement, la plus élevée pouvant être obtenue pour le paramètre de maille imposé par la couche tampon. Et la jonction centrale, agencée entre les deux précédentes, présente une bande interdite de largeur intermédiaire. Il est également possible d'utiliser plus de trois jonctions, dont la largeur de bande interdite augmente avec le rang à partir du substrat. Il est également possible, mais moins intéressant, de se limiter à deux seules jonctions.

Une cellule photovoltaïque selon un premier mode de réalisation de l'invention présente une jonction inférieure en Ga_{0,638}In_{0,362}As (Eg=0,941), une jonction centrale en (Al_{0,5}Ga_{0,5})_{0,644}In_{0,356}As (Eg=1,412 eV) et une jonction supérieure en Al_{0,65}In_{0,35}As (Eg=1,882 eV). Le paramètre de maille de ces matériaux vaut a=5,8 Å (limite inférieure de la région 12), ce qui correspond à une couche tampon en AlAs_{0,71}Sb_{0,29}.

Une cellule photovoltaïque selon un deuxième mode de réalisation de l'invention présente une jonction inférieure en Ga_{0,6}In_{0,4}As (Eg=0,898), une jonction centrale en (Al_{0,5}Ga_{0,5})_{0,606}In_{0,394}As (Eg= 1,364 eV) et une jonction supérieure en Al_{0,612}In_{0,388}As (Eg=1,829 eV). Le paramètre de maille de ces matériaux vaut a=5,815 Å (partie centrale de la région 12), ce qui correspond à une couche tampon en AlAs_{0,675}Sb_{0,325}.

Une cellule photovoltaïque selon un troisième mode de réalisation de l'invention présente une jonction inférieure en Ga_{0,563}In_{0,437}As (Eg=0,854), une jonction centrale en (Al_{0,5}Ga_{0,5})_{0,569}In_{0,431}As (Eg=1,315 eV) et une jonction supérieure en Al_{0,575}In_{0,425}As (Eg=1,776 eV). Le paramètre de maille de ces matériaux vaut a=5,83 Å (limite supérieure de la région 12), ce qui correspond à une couche tampon en AlAs_{0,64}Sb_{0,46}.

Une cellule photovoltaïque selon un quatrième mode de réalisation de l'invention présente une jonction inférieure en Ga_{0,468}In_{0,532}As (Eg=0,751), une jonction centrale en (Al_{0,5}Ga_{0,5})_{0,463}In_{0,537}As (Eg= 1,135 eV) et une jonction supérieure en Al_{0,477}In_{0,523}As (Eg=1,52 eV). Le paramètre de maille de ces matériaux vaut a=5,869 Å (limite supérieure de la région 11), ce qui correspond à une couche tampon en AlAs_{0,56}Sb_{0,44}.

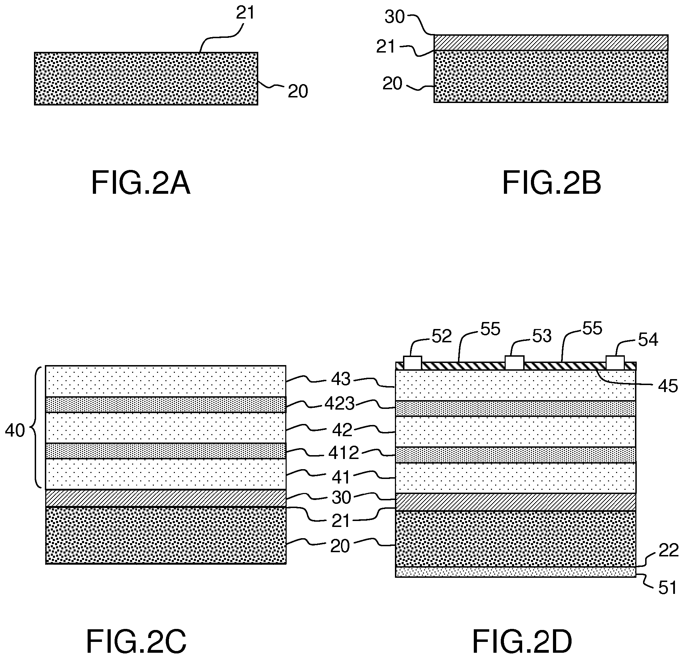

Les figures 2A à 2D illustrent les différentes étapes d'un procédé de fabrication d'une cellule photovoltaïque selon un mode de réalisation de l'invention.

La figure 2A montre le substrat en silicium monocristallin 20, présentant une surface supérieure 21 d'orientation (100).

Dans une première étape du procédé (figure 2B), une couche tampon 30 en alliage Al-V-Sb, notamment de formule AlAsₓSb₁₋ₓ (par exemple AlAs_{0.675}Sb_{0.325} qui a un paramètre de maille a=5.815 Å) et d'épaisseur préférentiellement comprise entre 2 et 100 nm, par exemple égale à 10 nm, est déposée sur la surface 21 du substrat. Cette étape peut être mise en œuvre, de préférence, par épitaxie par jet moléculaire à sources gazeuses (GS-MBE) ou par épitaxie en phase vapeur aux organométalliques (MOVPE).

Dans une deuxième étape du procédé (figure 2C), une hétérostructure active 40 est déposée sur la couche tampon. Cette hétérostructure est réalisée à partir de plusieurs alliages ternaires - ou à la limite binaires - de la famille (Al_{z}Ga_{1-z})_{w}In_{1-w}As_{1-y}P_{y}. Dans l'exemple de la figure, l'hétérostructure 40 comprend une jonction PN inférieure 41 présentant une largeur de bande interdite de l'ordre de 0,9 eV, une première jonction tunnel 412, une jonction PN centrale 42 présentant une largeur de bande interdite de l'ordre de 1,35 eV, une seconde jonction tunnel 423 et une jonction PN supérieure 43 présentant une largeur de bande interdite de l'ordre de 1,8 eV. Comme la précédente, cette étape peut être mise en œuvre, de préférence, par épitaxie par jet moléculaire à sources gazeuses (GS-MBE) ou par épitaxie en phase vapeur aux organométalliques (MOVPE). Il est possible de réaliser les deux étapes de croissance par un même processus de croissance, ou par deux processus distincts, optimisés séparément.

Ensuite, au moins un contact électrique inférieur 51 est déposé sur la surface inférieure du substrat, et au moins un contact électrique supérieur 52, 53, 54 est déposé sur la face supérieure 45 de l'hétérostructure 40. Avantageusement, un revêtement antireflet 55 peut être déposé sur cette même face supérieure. La figure 2D montre la cellule photovoltaïque complète, obtenue à l'issue du procédé.

Seul le cas où la couche tampon est en AlAsSb a été considéré en détail, mais ce cas n'est pas limitatif. Une alternative est constituée, par exemple, par AlPSb.

## Revendications

1. Cellule photovoltaïque multi-jonctions comprenant :
- un substrat (20) en silicium monocristallin ;
- une couche tampon (30) déposée par épitaxie au-dessus dudit substrat ; et
- une hétérostructure active (40) déposée par épitaxie au-dessus de ladite couche tampon, formée d'au moins deux alliages différents choisis parmi les familles AlGaInAs et GaInAsP présentant des paramètres de maille adaptés entre eux et avec celui de la couche tampon et comprenant au moins deux jonctions PN empilées (41, 42, 43) présentant des largeurs de bande interdite différentes,
**caractérisée en ce que** la couche tampon (30) est en alliage au moins ternaire de type III-V comprenant de l'aluminium, de l'antimoine et au moins un autre élément du groupe V.

2. Cellule photovoltaïque multi-jonctions selon la revendication 1 dans laquelle les alliages choisis parmi les familles AlGaInAs et GaInAsP formant ladite hétérostructure active présentent un paramètre de maille compris entre 5,6533 Å et 5,869 Å.

3. Cellule photovoltaïque multi-jonctions selon la revendication 1 dans laquelle les alliages choisis parmi les familles AlGaInAs et GaInAsP formant ladite hétérostructure active présentent un paramètre de maille compris entre 5,80 Å et 5,83 Å.

4. Cellule photovoltaïque multi-jonctions selon l'une des revendications précédentes dans laquelle ladite couche tampon est en alliage AlAsₓSb₁₋ₓ, avec 0,56≤x<1 et de préférence avec 0,644≤x≤0,707.

5. Cellule photovoltaïque multi-jonctions selon l'une des revendications précédentes dans laquelle ladite couche tampon présente une épaisseur comprise entre 2 et 100 nm.

6. Cellule photovoltaïque multi-jonctions selon l'une des revendications précédentes dans laquelle ladite hétérostructure active comprend au moins une jonction tunnel (412, 423) séparant deux dites jonctions PN.

7. Cellule photovoltaïque multi-jonctions selon l'une des revendications précédentes dans laquelle ladite hétérostructure active comprend au moins trois jonctions PN empilées présentant des largeurs de bande interdite croissantes suivant leur ordre à partir du substrat.

8. Cellule photovoltaïque multi-jonctions selon l'une des revendications précédentes dans laquelle ledit substrat en silicium monocristallin présente une surface (21) d'orientation (100) sur laquelle est déposée ladite couche tampon.

9. Procédé de fabrication d'une cellule photovoltaïque multi-jonctions comprenant les étapes suivantes :
a) fabrication, par dépôt épitaxial sur une surface (21) d'un substrat (20) en silicium monocristallin, d'une couche tampon (30) en alliage de type III-V comprenant au moins de l'aluminium, de l'antimoine et au moins un autre élément du group V ; et
b) fabrication, par dépôt épitaxial sur ladite couche tampon, d'une hétérostructure active (40) formée d'au moins deux alliages différents choisis parmi les familles AlGaInAs et GaInAsP présentant des paramètres de maille adaptés entre eux et avec celui de la couche tampon et comprenant au moins deux jonctions PN (41, 42, 43) empilées présentant des largeurs de bande interdite différentes.

10. Procédé selon la revendication 9 dans lequel lesdites étapes a) et b) sont mises en œuvre par au moins une méthode choisie parmi l'épitaxie par jet moléculaire à sources gazeuses et l'épitaxie en phase vapeur aux organométalliques.

11. Procédé selon l'une des revendications 9 et 10 dans lequel, dans ladite étape a), la couche tampon est fabriquée par dépôt épitaxial sur une surface (100) dudit substrat en silicium monocristallin.

12. Procédé selon l'une des revendications 9 à 11 dans lequel ladite couche tampon est en alliage AlAsₓSb₁₋ₓ, avec 0,56≤x<1 et de préférence avec 0,644≤x≤0,707.

13. Procédé selon l'une des revendications 9 à 12 dans lequel ladite couche tampon présente une épaisseur comprise entre 2 et 100 nm.

14. Procédé selon l'une des revendications 9 à 13 dans lequel les alliages choisis parmi les familles AlGaInAs et GaInAsP formant ladite hétérostructure active présentent un paramètre de maille compris entre 5,6533 Å et 5,869 Å.

15. Procédé selon l'une des revendications 9 à 13 dans lequel les alliages choisis parmi les familles AlGaInAs et GaInAsP formant ladite hétérostructure active présentent un paramètre de maille compris entre 5,80 et 5,83 Å.

16. Procédé selon l'une des revendications 9 à 15 comprenant également l'étape suivante
c) réalisation d'un premier contact électrique (51) sur une surface (22) dudit substrat en silicium monocristallin opposée à celle sur laquelle a été fabriquée la couche tampon, et d'au moins un second contact électrique (52, 53, 54) sur une surface (45) de ladite hétérostructure active opposée audit substrat.

## Patentansprüche

1. Photovoltaische Zelle mit mehreren Übergängen, die Folgendes umfasst:
- ein Substrat (20) aus monokristallinem Silicium;
- eine Pufferschicht (30), die durch Epitaxie auf dem Substrat abgeschieden ist; und
- eine aktive Heterostruktur (40), die durch Epitaxie auf der Pufferschicht abgeschieden und aus mindestens zwei verschiedenen Legierungen gebildet ist, ausgewählt aus den Familien AlGaInAs und GalnAsP, deren Gitterparameter aneinander und an die Pufferschicht angepasst sind, und die mindestens zwei gestapelte PN-Übergänge (41, 42, 43) mit unterschiedlichen verbotenen Bandbreiten umfasst,
**dadurch gekennzeichnet, dass** die Pufferschicht (30) aus einer mindestens ternären Legierung vom III-V-Typ besteht, die Aluminium, Antimon und mindestens ein weiteres Element aus der V-Gruppe umfasst.

2. Photovoltaikzelle mit mehreren Übergängen nach Anspruch 1, wobei die aus den Familien AlGaInAs und GalnAsP ausgewählten Legierungen, die die aktive Heterostruktur bilden, einen Gitterparameter im Bereich zwischen 5,6533 Å und 5,869 Å aufweisen.

3. Photovoltaikzelle mit mehreren Übergängen nach Anspruch 1, wobei die aus den Familien AlGaInAs und GalnAsP ausgewählten Legierungen, die die aktive Heterostruktur bilden, einen Gitterparameter im Bereich zwischen 5,80 Å und 5,83 Å aufweisen.

4. Photovoltaikzelle mit mehreren Übergängen nach einem der vorherigen Ansprüche, wobei die Pufferschicht aus einer AlAsₓSb₁₋ₓ-Legierung hergestellt ist, mit 0,56≤x<1 und vorzugsweise mit 0,644≤x≤0,707.

5. Photovoltaikzelle mit mehreren Übergängen nach einem der vorherigen Ansprüche, wobei die Dicke der Pufferschicht zwischen 2 und 100 nm liegt.

6. Photovoltaikzelle mit mehreren Übergängen nach einem der vorherigen Ansprüche, wobei die aktive Heterostruktur mindestens einen Tunnelübergang (412, 423) umfasst, der zwei der PN-Übergänge trennt.

7. Photovoltaische Zelle mit mehreren Übergängen nach einem der vorherigen Ansprüche, wobei die aktive Heterostruktur mindestens drei gestapelte PN-Übergänge mit verbotenen Bandbreiten umfasst, die sich entsprechend ihrer Reihenfolge vom Substrat aus schneiden.

8. Photovoltaische Zelle mit mehreren Übergängen nach einem der vorherigen Ansprüche, wobei das monokristalline Siliciumsubstrat eine Orientierungs-(100)-Fläche (21) aufweist, auf der die Pufferschicht abgesetzt ist.

9. Verfahren zum Herstellen einer photovoltaischen Zelle mit mehreren Übergängen, das die folgenden Schritte umfasst:
a) Herstellen, durch epitaktische Abscheidung auf einer Oberfläche (21) eines Substrats (20) aus monokristallinem Silicium, einer Pufferschicht (30) aus einer Legierung vom III-V-Typ, die mindestens Aluminium, Antimon und mindestens ein anderes Element aus der V-Gruppe umfasst; und
b) Herstellen, durch epitaktische Abscheidung auf der Pufferschicht, einer aktiven Heterostruktur (40), die aus mindestens zwei verschiedenen Legierungen gebildet ist, die aus den Familien AlGaInAs und GalnAsP ausgewählt sind, deren Gitterparameter aneinander und an die Pufferschicht angepasst sind, und wobei die Heterostruktur mindestens zwei gestapelte PN-Übergänge (41, 42, 43) mit unterschiedlichen verbotenen Bandbreiten aufweist.

10. Verfahren nach Anspruch 9, wobei die Schritte a) und b) durch mindestens ein Verfahren realisiert werden, das aus Gasquellen-Molekularstrahlepitaxie und metallorganischer Dampfphasenepitaxie ausgewählt ist.

11. Verfahren nach einem der Ansprüche 9 und 10, wobei in Schritt a) die Pufferschicht durch epitaktische Abscheidung auf einer Oberfläche (100) des monokristallinen Siliciumsubstrats hergestellt wird.

12. Verfahren nach einem der Ansprüche 9 bis 11, wobei die Pufferschicht aus einer AlAsₓSb₁₋ₓ-Legierung hergestellt wird, mit 0,56≤x<1 und vorzugsweise mit 0,644≤x≤0,707.

13. Verfahren nach einem der Ansprüche 9 bis 12, wobei die Dicke der Pufferschicht zwischen 2 und 100 nm liegt.

14. Verfahren nach einem der Ansprüche 9 bis 13, wobei die aus den Familien AlGaInAs und GalnAsP ausgewählten Legierungen, die die aktive Heterostruktur bilden, einen Gitterparameter im Bereich zwischen 5,6533 Å und 5,869 Å aufweisen.

15. Verfahren nach einem der Ansprüche 9 bis 13, wobei die aus den Familien AlGaInAs und GalnAsP ausgewählten Legierungen, die die aktive Heterostruktur bilden, einen Gitterparameter im Bereich zwischen 5,80 Å und 5,83 Å aufweisen.

16. Verfahren nach einem der Ansprüche 9 bis 15, das ferner den folgenden Schritt beinhaltet:
c) Herstellen eines ersten elektrischen Kontakts (51) auf einer Oberfläche (22) des monokristallinen Siliciumsubstrats gegenüber der, auf der die Pufferschicht hergestellt wurde, und Herstellen mindestens eines zweiten elektrischen Kontakts (52, 53, 54) auf einer Oberfläche (45) der aktiven Heterostruktur gegenüber dem Substrat.

## Claims

1. A multiple-junction photovoltaic cell comprising:
- a substrate (20) of monocrystalline silicon;
- a buffer layer (30) deposited by epitaxy on top of said substrate; and
- an active heterostructure (40) deposited by epitaxy on top of said buffer layer, formed by at least two different alloys selected from the AlGaInAs and GaINAsP families having mesh parameters that are matched with one another and with the parameter of the buffer layer and comprising at least two stacked PN junctions (41, 42, 43) having different forbidden bandwidths,
**characterised in that** the buffer layer (30) is made of an at least ternary III-V type alloy comprising aluminium, antimony and at least one other element from the V group.

2. The multiple-junction photovoltaic cell according to claim 1, wherein the alloys selected from the AlGaInAs and GaINAsP families forming said active heterostructure have a mesh parameter ranging between 5.6533 Å and 5.869 Å.

3. The multiple-junction photovoltaic cell according to claim 1, wherein the alloys selected from the AlGaInAs and GaINAsP families forming said active heterostructure have a mesh parameter ranging between 5.80 Å and 5.83 Å.

4. The multiple-junction photovoltaic cell according to one of the preceding claims, wherein said buffer layer is made of AlAsₓSb₁₋ₓ alloy, with 0.56≤x<1 and preferably with 0.644≤x≤0.707.

5. The multiple-junction photovoltaic cell according to one of the preceding claims, wherein the thickness of said buffer layer ranges between 2 and 100 nm.

6. The multiple-junction photovoltaic cell according to one of the preceding claims, wherein said active heterostructure comprises at least one tunnel junction (412, 423) separating two of said PN junctions.

7. The multiple-junction photovoltaic cell according to one of the preceding claims, wherein said active heterostructure comprises at least three stacked PN junctions having forbidden bandwidths intersecting in accordance with their order from the substrate.

8. The multiple-junction photovoltaic cell according to one of the preceding claims, wherein said monocrystalline silicon substrate has an orientation (100) surface (21), on which said buffer layer is deposited.

9. A method for manufacturing a multiple-junction photovoltaic cell comprising the following steps:
a) manufacturing, by epitaxial deposition on a surface (21) of a substrate (20) of monocrystalline silicon, a buffer layer (30) made of III-V type alloy comprising at least aluminium, antimony and at least one other element from the V group; and
b) manufacturing, by epitaxial deposition on said buffer layer, an active heterostructure (40) formed by at least two different alloys selected from the AlGaInAs and GaINAsP families having mesh parameters that are matched with one another and with the parameter of the buffer layer and comprising at least two stacked PN junctions (41, 42, 43) having different forbidden bandwidths.

10. The method according to claim 9, wherein said steps a) and b) are implemented by at least one method selected from gas source molecular beam epitaxy and organometallic vapour phase epitaxy.

11. The method according to one of claims 9 and 10, wherein, in said step a), the buffer layer is manufactured by epitaxial deposition on a surface (100) of said monocrystalline silicon substrate.

12. The method according to one of claims 9 to 11, wherein said buffer layer is made of AlAsₓSb₁₋ₓ alloy, with 0.56≤x<1 and preferably with 0.644≤x≤0.707.

13. The method according to one of claims 9 to 12, wherein the thickness of said buffer layer ranges between 2 and 100 nm.

14. The method according to one of claims 9 to 13, wherein the alloys selected from the AlGaInAs and GaINAsP families forming said active heterostructure have a mesh parameter ranging between 5.6533 Å and 5.869 Å.

15. The method according to one of claims 9 to 13, wherein the alloys selected from the AlGaInAs and GaINAsP families forming said active heterostructure have a mesh parameter ranging between 5.80 Å and 5.83 Å.

16. The method according to one of claims 9 to 15, further comprising the following step:
c) producing a first electric contact (51) on a surface (22) of said monocrystalline silicon substrate opposite that on which the buffer layer has been manufactured, and producing at least one second electric contact (52, 53, 54) on a surface (45) of said active heterostructure opposite said substrate.
